# EUROPÄISCHE PATENTSCHRIFT

(11) **EP 1 088 351 B1**
(45) Veröffentlichungstag und Bekanntmachung des Hinweises auf die Patenterteilung: **28.08.2002**
(21) Anmeldenummer: 99936402.9
(22) Anmeldetag: 02.06.1999
(51) Int. Cl.: H01L 39/00

(54) **STROMBEGRENZUNGSEINRICHTUNG MIT LEITERBAHNANORDNUNG AUS HOCH-Tc-SUPRALEITERMATERIAL SOWIE VERFAHREN ZUR HERSTELLUNG DER EINRICHTUNG**
CURRENT LIMITING DEVICE WITH PRINTED CONDUCTOR SYSTEM MADE OF A SUPERCONDUCTIVE MATERIAL HAVING A HIGH CRITICAL TEMPERATURE (Tc) AND METHOD FOR PRODUCING SAID DEVICE
DISPOSITIF LIMITEUR DE COURANT COMPORTANT UN ENSEMBLE DE TRACES CONDUCTEURS REALISE DANS UN MATERIAU SUPRACONDUCTEUR A TEMPERATURE CRITIQUE (Tc) ELEVEE, ET PROCEDE DE PRODUCTION DUDIT DISPOSITIF

(30) Priorität: 18.06.1998 DE 19827227
(43) Veröffentlichungstag der Anmeldung: 04.04.2001
(73) Patentinhaber: SIEMENS AKTIENGESELLSCHAFT, 80333 München (DE)
(72) Erfinder: HEISMANN, Björn, D-91052 Erlangen (DE)
(86) Internationale Anmeldenummer: DE9901634
(87) Internationale Veröffentlichungsnummer: WO99066566

(56) Entgegenhaltungen:
- DE-A- 19 520 205
- PATENT ABSTRACTS OF JAPAN vol. 018, no. 425 (E-1590), 9. August 1994 (1994-08-09) & JP 06 132571 A (SUMITOMO ELECTRIC IND LTD), 13. Mai 1994 (1994-05-13)
- PATENT ABSTRACTS OF JAPAN vol. 013, no. 277 (E-778), 26. Juni 1989 (1989-06-26) & JP 01 064272 A (TOSHIBA CORP), 10. März 1989 (1989-03-10)
- PATENT ABSTRACTS OF JAPAN vol. 013, no. 323 (E-791), 21. Juli 1989 (1989-07-21) & JP 01 089921 A (TOSHIBA CORP), 5. April 1989 (1989-04-05)

## Beschreibung

Die Erfindung bezieht sich auf eine Strombegrenzungseinrichtung mit einem zumindest teilweise aus elektrisch isolierendem Material bestehenden Trägerkörper, mit wenigstens einer auf dem Trägerkörper befindlichen Leiterbahnanordnung mit metalloxidischem Hoch-T_{c}-Supraleitermaterial sowie mit Endstücken der Leiterbahnanordnung zur Kontaktierung mit Anschlußleitern. Dabei weist die Leiterbahnanordnung mehrere zwischen ihren Endstücken parallelgeschaltete, untereinander beabstandete Teilleiter mit zumindest annähernd gleicher Länge auf. Die Erfindung betrifft ferner ein Verfahren zur Herstellung einer solchen Strombegrenzungseinrichtung. Eine entsprechende Einrichtung und ein Verfahren zu deren Herstellung gehen aus Patent Abstracts of Japan, Vol. 018, Nr. 425 (E-1590), 9. August 1994 & JP 06-132571 A hervor.

In elektrischen Wechselstromversorgungsnetzen können Kurzschlüsse und elektrische Überschläge nicht mit Sicherheit vermieden werden. Dabei steigt der Wechselstrom im betroffenen Stromkreis sehr schnell, d.h. in der ersten Halbwelle des Stromes, auf ein Vielfaches seines Nennwertes an, bis er durch geeignete Sicherungs- oder Schaltmittel unterbrochen wird. Als Folge davon treten in allen betroffenen Netzkomponenten wie Leitungen und Sammelschienen, Schaltern oder Transformatoren erhebliche thermische sowie mechanische Belastungen durch Stromkräfte auf. Da diese kurzzeitigen Lasten mit dem Quadrat des Stromes zunehmen, kann eine sichere Begrenzung des Kurzschlußstromes auf einen niedrigeren Spitzenwert die Anforderungen an die Belastungsfähigkeit dieser Netzkomponenten erheblich reduzieren. Dadurch lassen sich Kostenvorteile erzielen, etwa beim Aufbau neuer als auch beim Ausbau bestehender Netze, indem durch Einbau von Strombegrenzungseinrichtungen ein Austausch von Netzkomponenten gegen höher belastbare Ausführungsformen vermieden werden kann.

Mit supraleitenden Strombegrenzungseinrichtungen vom resistiven Typ kann der Stromanstieg nach einem Kurzschluß auf einen Wert von wenigen Vielfachen des Nennstromes begrenzt werden; darüber hinaus ist eine solche Begrenzungseinrichtung kurze Zeit nach Abschalten wieder betriebsbereit. Sie wirkt also wie eine schnelle, selbstheilende Sicherung. Außerdem gewährleistet sie eine hohe Betriebssicherheit, da sie passiv wirkt, d.h. autonom ohne vorherige Detektion des Kurzschlusses und ohne aktive Auslösung durch ein Schaltsignal arbeitet.

Resistive supraleitende Strombegrenzungseinrichtungen der eingangs genannten Art bilden eine seriell in einen Stromkreis einzufügende supraleitende Schaltstrecke. Dabei wird der Übergang einer supraleitenden Leiterbahnanordnung vom praktisch widerstandslosen kalten Betriebszustand unterhalb der Sprungtemperatur T_{c} des Supraleitermaterials in den normalleitenden Zustand über T_{c} (sogenannter Phasenübergang) ausgenutzt, wobei der nun vorhandene elektrische Widerstand Rₙ der Leiterbahnanordnung den Strom auf eine akzeptable Höhe I = U/Rₙ begrenzt. Die Erwärmung über die Sprungtemperatur T_{c} geschieht dabei durch Joule'sche Wärme in dem Supraleitermaterial der Leiterbahn selbst, wenn nach Kurzschluß die Stromdichte j über den kritischen Wert j_{c} des Supraleitermaterials ansteigt, wobei das Material auch unter der Sprungtemperatur T_{c} bereits einen endlichen elektrischen Widerstand aufweisen kann. Im begrenzenden Zustand oberhalb der Sprungtemperatur T_{c} fließt in dem die Strombegrenzungseinrichtung enthaltenden Stromkreis ein Reststrom weiter, bis ein zusätzlicher mechanischer Trennschalter den Stromkreis völlig unterbricht.

Supraleitende Strombegrenzungseinrichtungen mit bekannten metalloxidischen Hoch-T_{c}-Supraleitermaterialien, deren Sprungtemperatur T_{c} so hoch liegt, daß sie mit flüssigem Stickstoff von 77 K im supraleitenden Betriebszustand zu halten sind, zeigen eine schnelle Zunahme des elektrischen Widerstandes beim Überschreiten der kritischen Stromdichte j_{c}. Die Erwärmung in den normalleitenden Zustand und somit die Strombegrenzung geschieht dabei in verhältnismäßig kurzer Zeit, so daß der Spitzenwert des Kurzschlußstromes auf einen Bruchteil des unbegrenzten Stromes, etwa auf den 3- bis 10-fachen Nennstrom begrenzt werden kann. Der supraleitende Strompfad der Leiterbahnanordnung ist dabei in Kontakt mit einem Kühlmittel, das ihn in verhältnismäßig kurzer Zeit nach einer Überschreitung der kritischen Stromdichte j_{c} in den supraleitenden Betriebszustand zurückzuführen vermag.

Eine aus der EP 0 523 374 A entnehmbare, entsprechend arbeitende resistive Strombegrenzungseinrichtung enthält als Leiterbahnanordnung einen mäanderförmig gewundenen elektrischen Leiter aus einem Hoch-T_{c}-Supraleitermaterial (Abkürzung: HTS-Material), der beispielsweise aus einer 5 mm dicken Platte aus dem HTS-Material mittels Schlitzungen herausgearbeitet ist. Der elektrische Leiter ist selbsttragend, kann jedoch zur Erhöhung der mechanischen Stabilität auf einem Trägerkörper angeordnet sein. Seine Endstücke sind als Kontaktstücke ausgebildet, an die externe Anschlußleiter zum Zweck der Einspeisung des zu begrenzenden Stromes anzuschließen sind.

Bei einer derartigen Leiterbahnanordnung mit einer einzigen, seriell in einen Stromkreis, eingesetzten Leiterbahn ergeben sich Probleme hinsichtlich der räumlichen Variation der kritischen Stromdichte j_{c} im Supraleitermaterial; d.h., es ergibt sich eine entsprechende Verteilung des kritischen Stromes I_{c}(x) mit 0 < x < 1, wobei 1 die Länge der Leiterbahn ist. Die Stelle x mit dem niedrigsten I_{c,min} bestimmt dann nicht nur den kritischen Strom I_{c;ges} ≅ I_{c,min} der gesamten Leiterbahn, sondern wird auch bei einem dynamischen Begrenzungsvorgang eines Kurzschlusses als erste resistiv und demzufolge in der Begrenzungsphase am stärksten ohmsch aufgeheizt. Die Folge davon ist, daß in solchen Strombegrenzungseinrichtungen aufgrund dieser "Schwachstellen" an der Stelle x die maximale Schaltleistung entsprechend gering ist.

Aus dem eingangs genannten Patent Abstract of Japan und der diesbezüglichen JP-A-Schrift geht eine Strombegrenzungseinrichtung hervor, deren Leiterbahnanordnung Anschlussleiter aufweist, zwischen deren Endstücken mehrere untereinander beabstandete Teilleiter mit zumindest annähernd gleicher Leiterlänge parallelgeschaltet sind. Durch die somit zu erreichende Aufteilung des zu begrenzenden Stromes auf mehrere Teilleiter wird in diesen eine entsprechende Verringerung des zu führenden Teilstromes erreicht, so dass der einen Schalt- bzw. Begrenzungsvorgang auslösende Strom entsprechend erhöht werden kann. Jedoch besteht dann an den Endstücken die Gefahr eines vorzeitigen Normalleitendwerdens, da dort bei der bekannten Begrenzungseinrichtung der Leiterquerschnitt gegenüber dem gesamten Querschnitt aller Teilleiter verhältnismäßig gering ist. Damit ist bei der bekannten Begrenzungseinrichtung nicht auszuschließen, dass die Schaltfunktion in unerwünschter Weise in den Verbindungsbereich zwischen den Endstücken und den an ihnen angeschlossenen Teilleitern verlagert wird. Wegen dieser "Schwachstellen" ist die maximale Schaltleistung der bekannten Einrichtung entsprechend begrenzt.

Aufgabe der vorliegenden Erfindung ist es deshalb, die Strombegrenzungseinrichtung mit den eingangs genannten Merkmalen dahingehend auszugestalten, daß mit ihr eine vergleichsweise höhere maximale Schaltleistung ermöglicht wird, wobei eine sichere Schaltfunktion im Bereich der Teilleiter gewährleistet sein soll. Außerdem soll ein Verfahren zu einer möglichst einfachen Herstellung einer solchen Begrenzungseinrichtung angegeben werden.

Diese Aufgabe wird bezüglich der Strombegrenzungseinrichtung mit den eingangs genannten Merkmalen erfindungsgemäß dadurch gelöst, daß die Leiterbahnbreite der Teilleiter jeweils gegenüber der Leiterbahnbreite der Endstücke zumindest annähernd auf den n-ten Teil verringert ist, wobei n die Anzahl der Teilleiter ist.

Aufgrund der erfindungsgemäßen Bemessung der Breite der Teilleiter in Abhängigkeit von der der supraleitenden Endstücke ist vorteilhaft die Gefahr vermindert, dass im Bereich der Endstücke der Leiterbahnanordnung durch zu hohe Ströme wegen eines dort zu geringen Leiterbahnquerschnittes eine strombegrenzende Schaltfunktion ausgelöst wird. D.h., mit den erfindungsgemäßen Maßnahmen ist beherrschbar, dass die Schaltfunktion erst im Bereich der Teilleiter erfolgt. Dort werden resistive Zonen mit geringerer kritischer Stromdichte j_{c} in den einzelnen Leiterbahnen niedrigeren Stromdichten, hingegen noch nicht beschaltete Bereiche mit höherem j_{c} größeren Stromdichten ausgesetzt. Daraus resultiert eine entsprechend geringere lokale thermische Belastung der Schwachstellen durch ohmsche Leistungsdissipation einerseits und ein zeitlich früheres und bei geringeren Nennspannungen auftretendes Schalten in den normalleitenden Zustand andererseits. Folglich wird vorteilhaft das supraleitende Material gleichmäßiger erwärmt, mechanisch geschont und wird eine schnellere Rückkühlung nach dem Begrenzungsvorgang ermöglicht. D.h., die mit der erfindungsgemäßen Ausgestaltung der Begrenzungseinrichtung verbundenen Vorteile sind darin zu sehen, daß bei Überströmen und damit im Begrenzungsfall eine Stromverteilung im Bereich der Teilleiter erreicht wird, die die Bedeutung der j_{c}-Variation und der Schwachstellen reduziert.

Besonders vorteilhaft ist es, wenn die Teilleiter der Leiterbahnanordnung derart auf dem Trägerkörper angeordnet werden, daß der größte Teil jedes Teilleiters einen allein ihm zugeordneten Oberflächenbereich des Trägerkörpers belegt, der räumlich getrennt ist von dem jedem weiteren Teilleiter zugeordneten Oberflächenbereich. Damit ist vorteilhaft eine möglichst große räumliche Trennung der einzelnen Teilleiter bzw. ihrer Strompfade zu gewährleisten, die zu einer entsprechend gleichmäßigeren ohmschen Aufheizung bei einem Phasenübergang vom supraleitenden in den normalleitenden Zustand führen.

Diese Wirkung ist insbesondere dann zu erreichen, wenn die Leiterbahnanordnung mindestens drei parallelgeschaltete Teilleiter aufweist.

Ein vorteilhaftes Verfahren zur Herstellung einer erfindungsgemäßen Strombegrenzungseinrichtung ist dadurch gekennzeichnet, daß ihre Leiterbahnanordnung mittels Strukturierung mindestens einer auf dem Trägerkörper direkt oder indirekt aufgebrachten Schicht aus dem Hoch-T_{c}-Supraleitermaterial erstellt wird. Mit an sich bekannten physikalischen oder chemischen Strukturierungsprozessen lassen sich nämlich die einzelnen Teilleiter auf verhältnismäßig einfache Weise ausbilden.

Weitere vorteilhafte Ausgestaltungen der erfindungsgemäßen Strombegrenzungseinrichtung bzw. des Verfahrens zu ihrer Herstellung gehen aus den jeweils abhängigen Unteransprüchen hervor.

Ausführungsbeispiele von erfindungsgemäßen Strombegrenzungseinrichtungen werden nachfolgend anhand der Zeichnung noch näher erläutert. Dabei zeigen jeweils schematisch deren
- Figur 1: einen Querschnitt durch einen Teil einer solchen Strombegrenzungseinrichtung,
- Figur 2: eine Aufsicht auf eine Leiterbahnanordnung dieser Strombegrenzungseinrichtung und
- Figur 3: eine Aufsicht auf eine weitere Ausführungsform einer Leiterbahnanordnung.

In den Figuren sind sich entsprechende Teile mit denselben Bezugszeichen versehen.

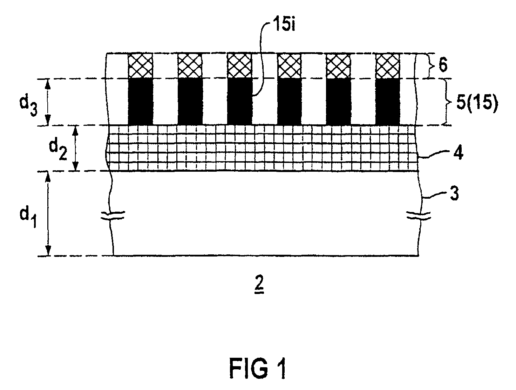

Bei der erfindungsgemäßen Strombegrenzungseinrichtung wird von an sich bekannten Ausführungsformen solcher Einrichtungen ausgegangen (vgl. z.B. die eingangs genannte "Patent Abstracts", die ebenfalls erwähnte EP 0523 374 A oder die *DE 195 20 205 A*). Der prinzipielle Aufbau dieser Einrichtung ist in Figur 1 als Ausschnitt aus einem Querschnitt durch eine solche Einrichtung angedeutet. Der allgemein mit 2 bezeichnete Aufbau umfaßt dabei einen Trägerkörper 3 mit einer Dicke d₁ und gegebenenfalls mindestens eine darauf aufgebrachte Zwischenschicht 4 einer Dicke d₂. Diese Zwischenschicht sei als Teil des Trägerkörpers angesehen. Auf sie ist eine Schicht 5 aus einem HTS-Material mit einer Dicke d₃ aufgebracht bzw. abgeschieden, die erfindungsgemäß strukturiert ist. Die HTS-Schicht kann mit mindestens einer weiteren Deckschicht wie z.B. einer Schutzschicht oder einer als Shuntwiderstand dienenden Schicht 6 abgedeckt sein. Eine solche Shuntwiderstandschicht ist für Strombegrenzeranwendungen insbesondere im Falle einer Verwendung eines isolierenden Trägerkörpers besonders vorteilhaft.

Der Trägerkörper 3 kann durch einen planaren oder gegebenenfalls auch gekrümmten Substratkörper wie z.B. in Rohrform gebildet sein. Er besteht zumindest teilweise aus einem elektrisch isolierenden Material. Hierfür geeignete Materialien sind Keramiken wie z.B. MgO, SrTiO₃, Al₂O₃ oder mit Y-stabilisiertes ZrO₂ (Abkürzung: "YSZ"). Besonders vorteilhaft werden Trägerkörper aus speziellem Glasmaterial vorgesehen, insbesondere wenn es um großflächige Körper geht. Eine entsprechende Platte kann beispielsweise eine Dicke d₁ von einigen Millimetern haben. Daneben sind auch aus metallischem und elektrisch isolierendem Material zusammengesetzte Trägerkörper geeignet. Insbesondere im Falle einer Verwendung von metallischen Teilen für den Trägerkörper ist die Zwischenschicht 5 aus einem elektrisch isolierenden Material erforderlich. Eine solche Zwischenschicht kann auch als sogenannte Pufferschicht benötigt werden, um einerseits eine Wechselwirkung zwischen dem auf sie aufzubringenden HTS-Material und dem Trägerkörpermaterial zu unterbinden und andererseits eine Textur des aufzubringenden HTS-Materials zu fördern. Bekannte Pufferschichtmaterialien, die im allgemeinen in einer Dicke zwischen 0,1 und 2 µm verwendet werden, sind YSZ, YSZ+CeO₂ (als Doppelschicht), YSZ+Sn-dotiertes In₂O₃ (als Doppelschicht), CeO₂, Pr₆O₁₁, MgO, SrTiO₃ oder La₁₋ₓCaₓMnO₃.

Als HTS-Materialien kommen alle bekannten metalloxidischen Hoch-T_{c}-Supraleitermaterialien wie insbesondere YBa₂Cu₃O₇₋ₓ bzw. RBa₂Cu₃O₇₋ₓ (mit R = seltenes Erdmetall), TlBa₂Ca₂Cu₃O₉₊ₓ, HgBa₂CaCu₂O₆₊ₓ, Bi₂Sr₂CaCu₂O₈₋ₓ oder (Bi,Pb)₂Sr₂Ca₂Cu₃O₁₁₋ₓ in Frage. Selbstverständlich können von diesen Materialien einzelne oder mehrere Komponenten in bekannter Weise durch andere Elemente zumindest teilweise substituiert sein. Diese Materialien werden mit einer Dicke d₃ aufgebracht, die im allgemeinen bis einige um betragen kann.

Wie in Figur 1 ferner angedeutet ist, soll zumindest die HTS-Schicht in besonderer Weise zu einer Leiteranordnung 15 strukturiert sein. Als Strukturierungsprozeß kommen alle hierfür bekannten physikalischen oder chemischen Verfahren in Frage. Beispielsweise kann die Strukturierung mittels eines Lasers vorgenommen werden. Nach dem Strukturierungsprozeß weist die Leiterbahnanordnung 15 mehrere Teilleiter 15ᵢ auf.

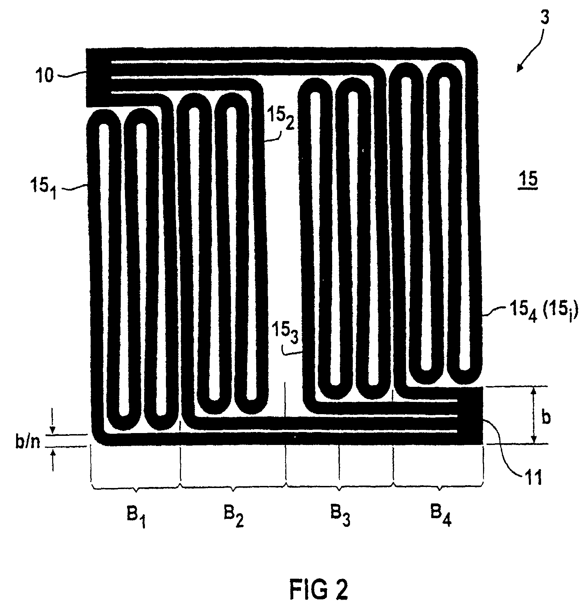

Eine konkrete Ausgestaltungsmöglichkeit der Leiterbahnanordnung 15 einer Strombegrenzungseinrichtung mit einer Unterteilung der Stromführung auf n parallelgeschaltete, zumindest weitgehend gleich lange Strompfade ist aus der Aufsicht der Figur 2 zu entnehmen. Die Leiteranordnung umfaßt zwei Endstücke 10 und 11 mit einer Leiterbahnbreite b zur Kontaktierung in bekannter Weise mit Anschlußleitern. Zwischen diesen Endstücken verlaufen n = 4 parallelgeschaltete Teilleiter 15ᵢ mit 1 ≤ i ≤ n. Die Leiterbahnbreite im Bereich dieser Teilleiter beträgt dabei etwa b/n. Vorteilhaft wird der Verlauf dieser Teilleiter so vorgesehen, daß eine möglichst große raumliche Trennung der Teilleiter untereinander erreicht wird. Dies wird gemäß dem dargestellten Ausführungsbeispiel dadurch erreicht, daß jedem der Teilleiter 15₁ bis 15₄ ein eigener Oberflächenbereich B₁ bis B₄ des Trägerkörpers 3 zugeordnet wird. In jedem dieser Oberflächenbereiche erstreckt sich der wesentlichste Teil - bis auf die direkten Verbindungsteilen mit den Endstücken - des jeweiligen Teilleiters. In den Bereichen verlaufen die Teilleiter vorteilhaft jeweils im wesentlichen mäanderförmig.

Die erfindungsgemässe Verkleinerung der Leiterbahnbreite b auf b/n im Bereich der Teilleiter 15ᵢ führt zum einen dazu, daß mikroskopische Variationen in der kritischen Stromdichte j_{c} nur in geringem Maße eine Rolle spielen. Die Leiterbahnanordnung wird deshalb im Schaltfalle auch bei geringen Nominalspannungen üblicherweise an mehr als n-Stellen resistiv; entsprechend geringer sind auch die lokalen Übertemperaturen. Zum anderen erhalten die einzelnen Strompfade mit dem Index i durch die räumliche Trennung entsprechend der makroskopischen j_{c}-Variation unterschiedliche kritische Ströme I_{c}(i). Wird nun bei einem Stromanstieg während eines Schaltvorganges der Pfad i mit dem geringsten kritischen Strom I_{c}(i) an einer Schwachstelle resistiv, so erhöht sich der entsprechende Pfadwiderstand R(i), und der Strom verteilt sich vermehrt auf die restlichen Pfade. Im Resultat fließt somit der Strom gewissermaßen um diese Schwachstelle herum. Entsprechend reduziert ist die im Pfad deponierte Leistung P(i) = I² (i)R(i), und die restlichen Pfade schalten durch die höhere Strombelastung zeitlich und bezüglich der anliegenden Spannung früher: Die Leiterbahnanordnung läßt folglich die Stromverteilung materialschonend auf das dynamische Zuschaltung resistiver Bahnbrücken reagieren. Es läßt sich feststellen, daß durch diese Eigenschaften vorteilhaft der Phasenübergang und die ohmsche Aufheizung bei einem Schaltvorgang räumlich homogenisiert werden. Auch erhöht sich der kritische Gesamtstrom I_{c,ges} einer Parallelanordnung gegenüber einer seriellen Anordnung spürbar, so daß höhere Nominalströme und damit entsprechend höhere Schaltleistungen bei annähernd gleicher Pfadlänge möglich werden.

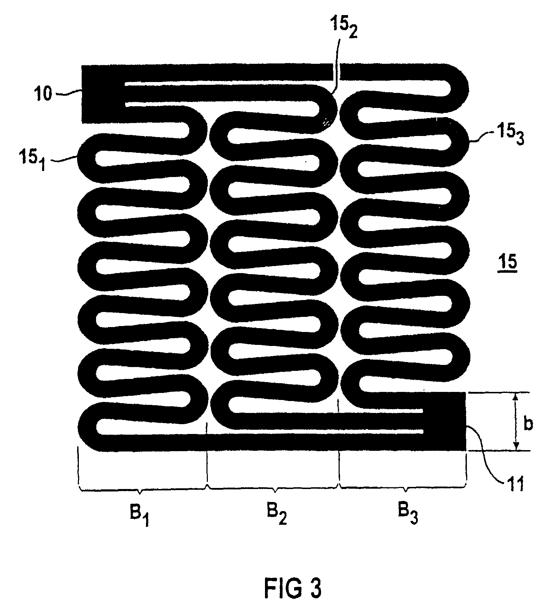

Die in Figur 3 gezeigte Ausführungsform einer Leiterbahnanordnung 15 unterscheidet sich von der nach Figur 2 zum einen in der Anzahl n=3 der Unterteilungen in somit drei Teilleiter 15₁ bis 15₃ in Oberflächenbereichen B₁ bis B₃. Zum anderen sind die mäanderförmigen Leiterwindungen in den einzelnen Oberflächenbereichen um 90° verdreht verlaufend gegenüber dem Verlauf der Leiterwindungen nach Figur 2.

Gemäß einem konkreten Ausführungsbeispiel für beide Ausführungsformen nach den Figuren 2 und 3 von Leiteranordnungen 15 für HTS-Strombegrenzereinrichtungen kann eine Breite b der ungeteilten Leiterbahn von etwa 1,2 cm und eine jeweilige Gesamtlänge der Strompfade von etwa 66 bzw. 65 cm vorgesehen sein. Mit entsprechenden Leiterbahnanordnungen 15 lassen sich dann unter Verwendung des HTS-Materials YBa₂Cu₃O₇₋ₓ mit einer kritischen Stromdichte j_{c} von etwa 10⁴ A/cm² Nennströme von etwa 1000 A schalten. Die einzelnen Strompfade formen dabei Bereiche, die im Mittel mehrere Zentimeter voneinander entfernt sind und somit in der Größenordnung der makroskopischen j_{c}-Schwankungen der HTS-Schicht liegen.

Bei den anhand der Figuren erläuterten Ausführungsformen von erfindungsgemäßen Strombegrenzungseinrichtungen wurde davon ausgegangen, daß deren Leiteranordnungen jeweils nur einseitig auf einen Trägerkörper aufgebracht sind. Selbstverständlich ist auch ein beidseitiges Belegen der gegenüberliegenden Flächen eines Trägerkörpers mit einer einzigen oder auch mit mehreren Leiterbahnanordnungen möglich.

## Patentansprüche

1. Strombegrenzungseinrichtung mit
- einem zumindest teilweise aus elektrisch isolierendem Material bestehenden Trägerkörper,
- wenigstens einer auf dem Trägerkörper befindlichen Leiterbahnanordnung mit metalloxidischem Hoch-T_{c}-Supraleitermaterial
sowie
- Endstücken der Leiterbahnanordnung zur Kontaktierung mit Anschlußleitern,
wobei die Leiterbahnanordnung mehrere zwischen ihren Endstücken parallelgeschaltete, untereinander beabstandete Teilleiter mit zumindest annähernd gleicher Leiterlänge aufweist,
**dadurch gekennzeichnet, daß** die Leiterbahnbreite der Teilleiter (15ᵢ; 15₁ bis 15₄) jeweils gegenüber der Leiterbahnbreite (b) der Endstücke (10, 11) zumindest annähernd auf den n-ten Teil verringert ist, wobei n die Anzahl der Teilleiter ist.

2. Strombegrenzungseinrichtung nach Anspruch 1,
**dadurch gekennzeichnet , daß** die Teilleiter (15₁ bis 15₄) der Leiterbahnanordnung (15) derart auf dem Trägerkörper (3) angeordnet sind, daß der größte Teil jedes Teilleiters einen allein ihm zugeordneten Oberflächenbereich (B₁ bis B₄) des Trägerkörpers belegt, der räumlich getrennt ist von dem jedem weiteren Teilleiter zugeordneten Oberflächenbereich.

3. Strombegrenzungseinrichtung nach Anspruch 2, **dadurch gekennzeichnet, daß** in den Oberflächenbereich (B₁ bis B₄) die Teilleiter (15₁ bis 15₄) im wesentlichen mäanderförmig verlaufen.

4. Strombegrenzungseinrichtung nach einem der vorangehenden Ansprüche, **gekennzeichnet durch** einen Trägerkörper (3) aus einem keramischen Material oder aus einem Glasmaterial.

5. Strombegrenzungseinrichtung nach einem der vorangehenden Ansprüche, **dadurch gekennzeichnet, daß** der Trägerkörper (3) mit mindestens einer Zwischenschicht (4) als Unterlage für die wenigstens eine Leiterbahnanordnung (15) versehen ist.

6. Strombegrenzungseinrichtung nach einem der vorangehenden Ansprüche, **dadurch gekennzeichnet, daß** die Leiterbahnanordnung (15) mit wenigstens einer weiteren Schicht (6) abgedeckt ist.

7. Strombegrenzungseinrichtung nach einem der vorangehenden Ansprüche, **dadurch gekennzeichnet, daß** der Trägerkörper (3) beidseitig mit mindestens einer Leiterbahnanordnung (15) versehen ist.

8. Verfahren zur Herstellung einer Strombegrenzungseinrichtung nach einem der vorangehenden Ansprüche, **dadurch gekennzeichnet, daß** die Leiterbahnanordnung (15) mittels Strukturierung mindestens einer auf dem Trägerkörper (3) direkt oder indirekt aufgebrachten Schicht aus dem Hoch-T_{c}-Supraleitermaterial erstellt wird.

9. Verfahren nach Anspruch 8, **dadurch gekennzeichnet, daß** zur Strukturierung ein physikalischer oder chemischer Prozeß vorgesehen wird.

## Claims

1. Current limiting device comprising
- a substrate which at least partially consists of electrically insulating material,
- at least one printed conductor arrangement consisting of metal-oxide superconductive material with a high T_{c}, which is located on the substrate, and
- end pieces of the printed conductor arrangement for establishing contact with connecting conductors,
the printed conductor arrangement exhibiting a number of mutually spaced-apart partial conductors which are connected in parallel between their end pieces and have at least approximately the same conductor length, **characterized in that** the printed conductor width of the partial conductors (15ᵢ; 15₁ to 15₄) is in each case reduced at least approximately to the nth part compared with the printed conductor width (b) of the end pieces (10, 11), n being the number of partial conductors.

2. Current limiting device according to Claim 1, **characterized in that** the partial conductors (15₁ to 15₄) of the printed conductor arrangement (15) are arranged on the substrate (3) in such a manner that the greatest proportion of each partial conductor occupies a surface area (B₁ to B₄) of the substrate which is only allocated to it and which is spatially separate from the surface area allocated to every other partial conductor.

3. Current limiting device according to Claim 2, **characterized in that** the partial conductors (15₁ to 15₄) extend essentially in a meander form in the surface area (B₁ to B₄).

4. Current limiting device according to one of the preceding claims, **characterized by** a substrate (3) of a ceramic material or of a glass material.

5. Current limiting device according to one of the preceding claims, **characterized in that** the substrate (3) is provided with at least one intermediate layer (4) as base for the at least one printed conductor arrangement (15).

6. Current limiting device according to one of the preceding claims, **characterized in that** the printed conductor arrangement (15) is covered with at least one further layer (6).

7. Current limiting device according to one of the preceding claims, **characterized in that** the substrate (3) is provided with at least one printed conductor arrangement (15) on both sides.

8. Method for producing a current limiting device according to one of the preceding claims, **characterized in that** the printed conductor arrangement (15) is generated by means of patterning of at least one layer of the superconductive material with a high T_{c}, which is applied directly or indirectly to the substrate (3).

9. Method according to Claim 8, **characterized in that** a physical or chemical process is provided for the patterning.

## Revendications

1. Dispositif limiteur de courant comprenant
- une pièce support constituée au moins en partie en un matériau isolant de l'électricité,
- au moins un ensemble de pistes conductrices en un matériau supraconducteur à température critique T_{c} élevée en oxyde métallique se trouvant sur la pièce support
ainsi que
- des embouts du dispositif à pistes conductrices pour établir le contact avec des conducteurs de connexion,
le dispositif à pistes conductrices comportant plusieurs sous-conducteurs ayant au moins approximativement la même longueur, qui sont à distance les uns des autres et qui sont montés en parallèle entre leurs embouts,
**caractérisé en ce que** la largeur de pistes conductrices des sous-conducteurs (15ᵢ, 15₁ à 15₄) est diminuée par rapport à la largeur (b) des pistes conductrices des embouts (10, 11) au moins approximativement au énième, n étant le nombre des sous-conducteurs.

2. Dispositif limiteur de courant suivant la revendication 1,
**caractérisé en ce que** les sous-conducteurs (15₁ à 15₄) de l'ensemble (15) de pistes conductrices sont disposés sur la pièce (3) support de façon que la plus grande partie de chaque sous-conducteur occupe une partie (B₁ à B₄) de la surface de la pièce support, qui lui est affectée à lui seul, et qui est séparée dans l'espace de la partie de surface associée à chaque autre sous-conducteur.

3. Dispositif limiteur de courant suivant la revendication 2, **caractérisé en ce que** les sous-conducteurs (15₁ à 15₄) s'étendent sensiblement sinueusement dans la partie (B₁ à B₄) de surface.

4. Dispositif limiteur de courant suivant l'une des revendications précédentes, **caractérisé par** une pièce (3) support en matériau céramique ou en matériau de verre.

5. Dispositif limiteur de courant suivant l'une des revendications précédentes, **caractérisé en ce que** la pièce (3) support est munie d'au moins une couche (4) intermédiaire servant de substrat pour le au moins un ensemble de pistes conductrices.

6. Dispositif limiteur de courant suivant l'une des revendications précédentes, **caractérisé en ce que** l'ensemble (15) de pistes conductrices est revêtu d'au moins une autre couche (6).

7. Dispositif limiteur de courant suivant l'une des revendications précédentes, **caractérisé en ce que** la pièce (3) support est munie sur les deux faces d'au moins un ensemble (15) de pistes conductrices.

8. Procédé de production d'un dispositif limiteur de courant suivant l'une des revendications précédentes, **caractérisé en ce que** l'on établit l'ensemble (15) de pistes conductrices en structurant au moins une couche en matériau supraconducteur à température critique T_{c} élevée déposée directement ou indirectement sur la pièce (3) support.

9. Procédé suivant la revendication 8, **caractérisé en ce que** l'on prévoit pour la structuration une opération physique ou chimique.
